(19) Europäisches Patentamt
European Patent Office
Office européen des brevets

(11) **EP 1 466 320 B1**

(12) **EUROPEAN PATENT SPECIFICATION**

(45) Date of publication and mention
of the grant of the patent:
**07.02.2007 Bulletin 2007/06**

(21) Application number: **02781516.6**

(22) Date of filing: **13.11.2002**

(51) Int Cl.:
***G10L 19/14*** (2006.01)

(86) International application number:
**PCT/IB2002/004776**

(87) International publication number:
**WO 2003/046889 (05.06.2003 Gazette 2003/23)**

(54) **SIGNAL CODING**

SIGNALKODIERUNG

CODAGE DE SIGNAL

(84) Designated Contracting States:
**AT BE BG CH CY CZ DE DK EE ES FI FR GB GR
IE IT LI LU MC NL PT SE SK TR**

(30) Priority: **30.11.2001 EP 01204653**

(43) Date of publication of application:
**13.10.2004 Bulletin 2004/42**

(73) Proprietor: **Koninklijke Philips Electronics N.V.
5621 BA Eindhoven (NL)**

(72) Inventors:
• **SCHUIJERS, Erik, G., P.
NL-5656 AA Eindhoven (NL)**
• **OOMEN, Arnoldus, W., J.
NL-5656 AA Eindhoven (NL)**

(74) Representative: **Groenendaal, Antonius W. M.
Philips
Intellectual Property & Standards
P.O. Box 220
5600 AE Eindhoven (NL)**

(56) References cited:
**EP-A- 0 858 067     US-A- 5 850 403**

• **MCCOURT P M ET AL: "Transform coding at 4.8
kbit/sec using interleaving of transform frames
and dual gain-shape vector quantisation"
STATISTICAL SIGNAL AND ARRAY
PROCESSING. MINNEAPOLIS, APR. 27 - 30, 1993,
PROCEEDINGS OF THE INTERNATIONAL
CONFERENCE ON ACOUSTICS, SPEECH, AND
SIGNAL PROCESSING (ICASSP), NEW YORK,
IEEE, US, vol. 4, 27 April 1993 (1993-04-27), pages
624-627, XP010110534 ISBN: 0-7803-0946-4**
• **ERZIN E ET AL: "INTERFRAME DIFFERENTIAL
VECTOR CODING OF LINE SPECTRUM
FREQUENCIES" SPEECH PROCESSING.
MINNEAPOLIS, APR. 27 - 30, 1993,
PROCEEDINGS OF THE INTERNATIONAL
CONFERENCE ON ACOUSTICS, SPEECH, AND
SIGNAL PROCESSING (ICASSP), NEW YORK,
IEEE, US, vol. 2, 27 April 1993 (1993-04-27), pages
II-25-II-28, XP000427716 ISBN: 0-7803-0946-4**

**Description**

Audio coding schemes are known which use frames that include a set of values representing (a component of) the audio signal in the time interval to which the frame relates. At least some frames relate to time intervals having an overlap in time. In order to achieve a low bit-rate, the redundancy between values obtained at successive time-instants can be exploited by employing, e.g. differential, coding techniques.

An object of the invention is to provide advantageous coding. To this end, the invention provides a method of coding, an encoder, a bit-stream, a storage medium, a method of decoding, a decoder, a transmitter, a receiver and a system as defined in the independent claims. Advantageous embodiments are defined in the dependent claims.

The paper "Transform Coding at 4.8 kbit/sec using interleaving of transform frames and dual gain-shape vector quantisation" by P.M. Court and H.A. Kaouri, ICASSP, New York, Vol. 4, April 1993, discloses the overlapping of frames in the transform domain before encoding. The overlapping is achieved by interleaving of transform domain frames.

European Patent Application EP 0 858 067 discloses the interleaving of multiple signal channels to obtain a one-dimensional signal sequence which is then coded while making use of any correlation between the signal samples. Two channels may be interleaved alternatively.

A first aspect of the invention, as defined by the appended independent claims, provides coding a signal, the coding comprising providing a first set of values related to subsequent times in a first time interval of the signal, providing a second set of values related to subsequent times in a second time interval of the signal, wherein the first time interval has an overlap (in time) with the second time interval, the overlap including at least two subsequent times of the second interval, wherein at least one of the values of the second set related to the at least two subsequent times in the overlap is differentially encoded with reference to a value of the first set which is closer in time to the at least one value of the second set than any other value in the second set.

By encoding at least one value of the second set with reference to a value of the first set which is closer in time to the at least one value of the second set than any other value in the second set, a better exploitation of redundancy in the values is achieved. This aspect of the invention is based on the insight that when using overlapping time intervals, it might happen that in the other set, a value is related to a time which time is closer to the time of the current value of the second set to be encoded than any value available in the second set. Because in general, values are more correlated when closer in time, the generally better correlation can be used to code the signal more efficiently.

The subsequent times may be time instants (or points) or time spans smaller than the time interval (e.g. related to sub-frames). The second time interval will usually be subsequent in time to the first time interval, but may also be preceding the first time interval.

The overlapping times are not necessarily identical, the times of the second time interval may have an offset relative to the times of the first time interval. In the case that the times are time instants, the differences in time between subsequent time instants in the first time interval are not necessarily the same as the differences in time between the subsequent time instants in the second time interval. Further, if the times are time spans, they have not necessarily the same length within the respective time interval or relative to the other time interval. In preferred embodiments the number of times per time interval is the same for the first time interval and the second time interval and the times are (substantially) evenly distributed over the respective time intervals.

The sets of values may be included in frames or sub-frames.

Although the invention is applicable to any coding scheme which uses frames related to overlapping time intervals and any kind of values, the invention is advantageously applied in a parametric audio coding schemes, wherein the values are e.g. gains of a noise component in the audio signal.

These and other aspects of the invention will be apparent from and elucidated with reference to the accompanying drawings.

In the drawings:

Fig. 1 shows an illustration of the use frames which relate to overlapping time intervals, with conventional differential encoding to illustrate the insight of the invention;
Fig. 2 shows encoding according to a first embodiment of the invention;
Fig. 3 shows encoding according to a second embodiment of the invention, and
Fig. 4 shows a system according to an embodiment of the invention.

The drawings only show those elements that are necessary to understand the embodiments of the invention. The numbers in the drawings denote serial numbers of the values in a given sub-frame, subsequent serial numbers being related to subsequent times in the respective time interval to which the given sub-frame relates.

In a preferred parametric coding scheme, the input signal is typically dissected into transient signal components, sinusoidal signal components and noise components. Reference is made to WO 01/69593-A1. The parameters representing the sinusoidal components are typically chosen to be amplitude, frequency and phase. For the transient components the extension of such parameters with an envelope description is an efficient representation of the transient component. With respect to the noise, the spectral shape and a gain parameter controlling a random noise generator, represent an efficient parametric representation. In order to encode all these parameters with sufficient low bit-rate, redundancy between these parameters at successive time-instances must be exploited. For example, in the case of the sinusoidal components, the amplitude and frequency parameters of a single component are slowly varying in time. It is therefore beneficial to encode the changes in amplitude and frequency. Per analysis frame a single parameter for frequency and amplitude is to be encoded.

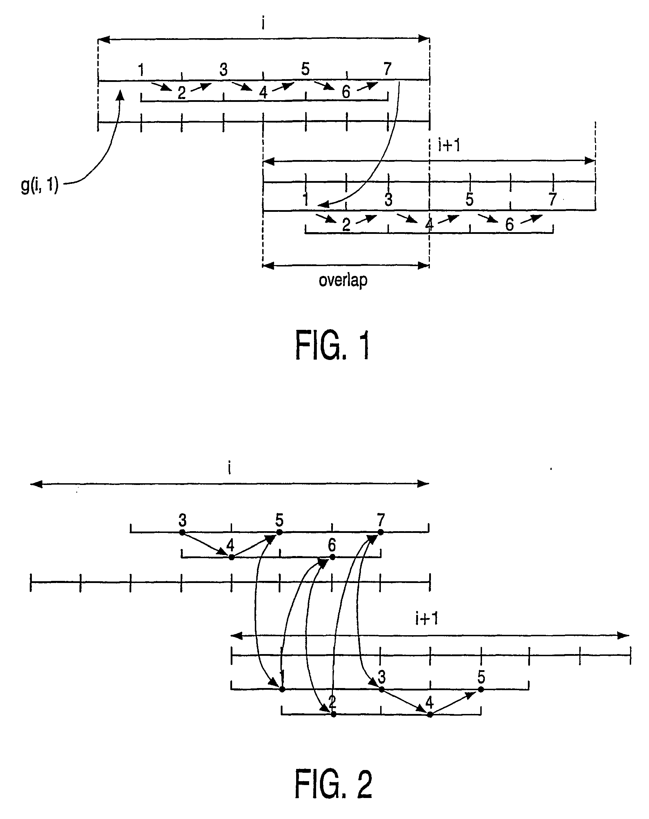

In the case of the parameterization of the noise signal, a number of e.g. 7 gain parameter values are obtained per sub-frame, each gain value representing the power in a sub-sub-frame where it relates to. A number of sub-frames are included in a noise frame. The analysis frames are e.g. 50% overlapping. This is visualized in Figure 1. In practical embodiments, the time spans of the sub-sub-frames are of a same or similar length for each sub-frame.

Due to the slowly varying nature of the gain parameters, redundancy is exploited by encoding these parameters differentially. For that purpose the estimated gain parameters are organized sequentially. The differences are subsequently entropy encoded.

$$... g(i\text{-}1,7)\ g(i,1)\ g(i,2)\ ...\ g(i,6)\ g(i,7)\ g(i\text{+}1,1)\ g(i\text{+}1,2)\ ...\ g(i\text{+}1,6)\ g(i\text{+}1,7)\ ...$$

where $g(a, b)$ denotes the $b^{th}$ noise gain representation level of sub-frame a. Finally these differential representation levels are entropy encoded using a Huffman table.

According to embodiments of the invention, the estimated parameter values, in this example the gain parameters, are organized such that the redundancy is even better exploited. With respect to conventional coding, a simple change to the bit-stream syntax results in an improvement in coding efficiency.

Approach 1

In the parametric coding example the estimated noise gains are organized as follows (see also Figure 2):

$$... g(i,3)\ g(i,4)\ g(i,5)\ g(i\text{+}1,1)\ g(i,6)\ g(i\text{+}1,2)\ g(i,7)\ g(i\text{+}1,3)\ g(i\text{+}1,4)\ g(i\text{+}1,5)\ ...$$

The thus obtained sequence of gain parameters is preferably differentially encoded.

Approach 2

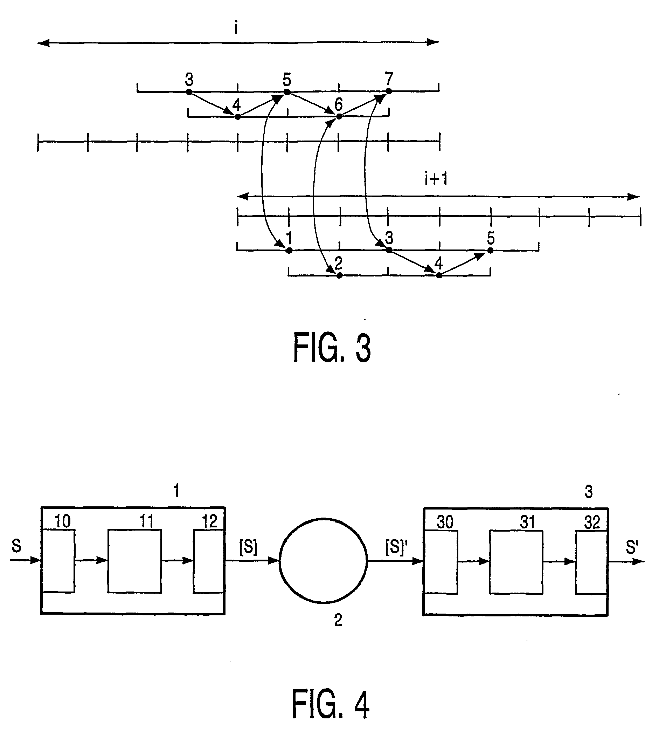

The following approach, which proved to be slightly more efficient in the case of the parametric coding example, is as follows (see also Figure 3):

Step A) first for frame i the gains are organized as: g(i,3) g(i, 4) g(i,5) g(i,6) g(i,7) which are then be (preferably differentially) encoded.
Step B) Then the pairs g(i,5) g(i+1,1), g(i,6) g(i+1,2) and g(i,7) g(i+1,3) are (preferably differentially) encoded

Approach 3

Further investigation showed that the three inter-frame differences g(i+1,1)-g(i,5), g(i+1,2)-g(i,6) and g(i+1,3)-g(i,7) have much similarity. Therefore, it is even more efficient to encode the mean m of these differences and then code the differences with respect to this mean. This thus means that an extra parameter, the mean difference, is included in the bit-stream.

As a comparison of the different approaches consider the following example:

| Gain value | Value |
|---|---|
| g(i,5) | 12 |
| g(i,6) | 16 |
| g(i,7) | 8 |
| g(i+1,1) | 15 |

(continued)

| Gain value | Value |
|---|---|
| g(i+1,2) | 20 |
| g(i+1,3) | 13 |

For the different approaches as described above using differential encoding this would deliver the sequences:

| Original approach | | Approach 1 | | Approach 2 | | Approach 3 | |
|---|---|---|---|---|---|---|---|
| ... | ... | ... | ... | ... | ... | ... | ... |
| +4 | (16-12) | +3 | (15-12) | +4 | (16-12) | +4 | (16-12) |
| -8 | (8-16) | +1 | (16-15) | -8 | (8-16) | -8 | (8-16) |
| +7 | (15-8) | +4 | (20-16) | +3 | (15-12) | +4 | (mean m*) |
| +5 | (20-5) | -12 | (8-20) | +4 | (20-16) | -1 | (15-12-m) |
| -7 | (20-13) | +5 | (13-8) | +5 | (13-8) | 0 | (20-16-m) |
| ... | ... | ... | ... | ... | ... | 1 | (13-8-m) |

* The mean m is calculated as ((15-12) + (20-16) + (13-8))/3 = 4.

Note that even though in approach 3 an extra parameter is added the resulting sequence can be encoded more efficiently.

In a practical embodiment of noise frame encoding, each sub-frame defines or updates filter parameters which remain constant over the sub-frame. Per sub-frame several subsequent gain parameter values are given which relate to subsequent times in the time interval to which the sub-frame relates. The sub-frames overlap in time. A refresh noise frame is defined which starts with a sub-frame comprising refresh filter parameters which are encoded as absolute filter parameters. Filter parameters in other sub-frames are mainly differentially encoded.

In a preferred practical embodiment, the following coding strategy is used:

For the first sub-frame of a 'refresh-frame' the first noise gain is coded absolutely. All following noise gains of that sub-frame are encoded differentially.

For all other sub-frames instead of encoding the difference $g(i+1,1)-g(i,7)$ the difference $g(i+1,1)-g(i,5)$ is encoded, thus exploiting the redundancy that is apparent between noise-gains that are analyzed at similar time-instances. The same is repeated for $g(i+1,2)$ and $g(i+1,3)$. So, instead of encoding the difference $g(i+1,2)-g(i+1,1)$ respectively $g(i+1,3)-g(i+1,2)$, the difference $g(i+1,2)-g(i,6)$ respectively $g(i+1,3)-g(i,7)$ is encoded (see also Figure 2).

In an even more preferred practical embodiment, the following coding strategy is used:

For the first sub-frame of a 'refresh-frame' the first noise gain is coded absolutely. All following noise gains of that sub-frame are encoded differentially.

For any other sub-frame i+1 the differences $g(i+1,1)-g(i,5)$, $g(i+1,2)-g(i,6)$ and $g(i+1,3)-g(i,7)$ and the mean value $m(i+1)$ of these differences is calculated. First the mean value $m(i+1)$ is encoded into the bit-stream, followed by the differences $g(i+1,1)-g(i,5)-m(i+1)$, $g(i+1,2)-g(i,6)-m(i+1)$ and $g(i+1,3)-g(i,7)-m(i+1)$ which represent the differences to the mean value. Finally the values $g(i+1,4)-g(i+1,3)$, $g(i+1,5)-g(i+1,4)$, $g(i+1,6)-g(i+1,5)$ and $g(i+1,7)-g(i+1,6)$ are encoded into the bit-stream.

Except for the first sub-frame of a refresh noise frame, first the mean $m(i+1)$ of the overlapping differences is inserted just after the differential parameters representing the filter. Immediately after the mean $m(i+1)$, the differences to the mean value $m(i+1)$ are inserted into the bit-stream. For the non-overlapping gain values the parameters are encoded differentially. This embodiment results in the following bit-stream syntax:

*first sub-frame of a refresh noise frame (in the above example sub-frame i)*

{

refresh filter parameters

first absolute gain value (e.g. $g(i,1)$)

differentially encoded further gain values (e.g. $g(i,2)...g(i,7)$)

}

*other sub-frames of a noise frame (refresh and non-refresh) (e.g. sub-frame i+1 in the above example)*

{

differentially encoded filter parameters

mean of the overlapping differences (e.g. $m(i+1)$)

differences of the overlapping gain values to the mean

differentially encoded non overlapping gain values

}

The mean differential gain coefficient $m(i+1)$ is preferably encoded by using a Huffman table. The differences to the mean $m(i+1)$ are also preferably encoded by using a Huffman table. The other differential noise parameters are also preferably encoded by use of a Huffman table.

In a decoder, the noise gain parameter values in sub-frame i+1 relating to the overlap are obtained by adding the mean $m(i+1)$ and the respective 'difference to the mean value' to the noise gain parameter value of the sub-frame i which value is used as reference value. For example in the above example (see Fig. 3), $g(i+1,3) = g(i,7) + m(i+1) + [g(i+1,3)-g(i,7)-m(i+1)]$.

Especially speech excerpts which may be critical for parametric encoding benefit from embodiments of the invention. The extra decoder complexity caused by the embodiments of the invention is negligible.

Fig. 4 shows a system according to an embodiment of the invention. The system comprises an apparatus 1 for transmitting or recording an encoded signal [S]. The apparatus 1 comprises an input unit 10 for receiving a signal S, which is preferably an audio signal. The input unit 10 may be an antenna, microphone, network connection, etc. The apparatus 1 further comprises an encoder 11 for encoding the signal S according to an above described embodiment of the invention (see in particular Figs. 2 and 3) in order to obtain an encoded signal. The encoded signal is furnished to an output unit 12 which transforms the encoded audio signal in bit-stream [S] having a suitable format for transmission or storage via a transmission medium or storage medium 2. The system further comprises a receiver or reproduction apparatus 3 which receives the encoded signal [S] in an input unit 30. The input unit 30 furnishes the encoded signal [S] to the decoder 31. The decoder 31 decodes the encoded signal by performing a decoding process which is an inverse operation of the encoding in the encoder 11. The decoder 31 furnishes the decoded signal S' to an output unit 32 that provides the decoded signal S'. The output unit 32 may be reproduction unit such as a speaker for reproducing the decoded signal S'. The output unit 32 may also be a transmitter for further transmitting the decoded signal S' for example over an in-home network, etc.

Application areas of embodiments of the invention are: Internet download, Internet Radio, Solid State audio.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. This word 'comprising' does not exclude the presence of other elements or steps than those listed in a claim. The invention can be implemented by means of hardware comprising several distinct elements, and by means of a suitably programmed computer. In a device claim enumerating several means, several of these means can be embodied by one and the same item of hardware.

**Claims**

1. A method of coding a signal, the method comprising:

   providing a first set of values related to subsequent times in a first time interval i of the signal,
   providing a second set of values related to subsequent times in a second time interval i+1 of the signal,
   the first time interval i having an overlap with the second time interval i+1, the overlap including at least two subsequent times of the second interval,

   wherein the second time interval will usually be subsequent in time to the first time interval, but may also be preceding the first time interval,
   wherein at least one of the values of the second set related to the at least two subsequent times in the overlap is differentially encoded with reference to a value of the first set which is closer in time to the at least one value of the second set than any other value in the second set.

2. A method as claimed in claim 1, wherein the overlap includes at least two times of the first time interval (i).

3. A method as claimed in claim 1 or 2, wherein $g(i,b)$ are the values in the first set (i) and $g(i+1,b)$ the values in the second set (i+1), wherein b denotes the serial number of a given value in a given set, subsequent serial numbers being related to subsequent times,
   the overlap including k times of the second time interval,
   wherein the values $g(i,b)$ of the first set (i) and of the values $g(i+1,b)$ of the second set (i+1) are encoded in the sequence:
   $g(i,n-k)$ $g(i,n-k+1)$ $g(i+1,1)$ $g(i,n-k+2)$ $g(i+1,2)$... $g(i,n)$ $g(i+1,k)$ $g(i+1,k+1)$ $g(i+1,k+2)$..., wherein n is the highest serial number in the first set (i).

4. A method as claimed in claim 1 or 2, wherein $g(i,b)$ are the values in the first set (i) and $g(i+1,b)$ the values in the second set (i+1), wherein b denotes the serial number of a given value in a given set, subsequent serial numbers being related to subsequent times,
   the overlap including k times of the second time interval,
   wherein the coding comprises:

   encoding the sequence ... $g(i,n-k)$ $g(i, n-k+ 1)$ $g(i,n-k+2)$ ... $g(i,n)$,
   encoding the sequence of inter-frame differences $g(i+1,1)-g(i,n-k+1)$, $g(i+1,2)-g(i,n-k+2)$ ...$g(i+1,k)-g(i,n)$, wherein n is the highest serial number in the first set.

5. A method as claimed in claim 4, wherein a mean $(m(i+1))$ of the inter-frame differences is determined and wherein the respective inter-frame differences are encoded as differences to said mean.

6. A method as claimed in any of the preceding claims, wherein a number of times in the first time interval (i) in the overlap is equal to a number of times in the second time interval (i+1) in the overlap.

7. A method as claimed in any of the preceding claims, wherein the values are values of a same type of parameter.

8. A method as claimed in any of the preceding claims, wherein the values are included in respective frames or sub-frames.

9. A method as claimed in any of the preceding claims, wherein the signal is an audio signal.

10. A method as claimed in claim 9, wherein the values are gain values of a noise component in the audio signal.

11. An encoder for coding a signal, the encoder comprising:

   means for providing a first set of values related to subsequent times in a first time interval i of the signal,
   means for providing a second set of values related to subsequent times in a second time interval i+1 of the signal,
   the first time interval i having an overlap with the second time interval i+1, the overlap including at least two subsequent times of the second interval,

wherein the second time interval will usually be subsequent in time to the first time interval, but may also be preceding the first time interval,

the encoder further comprising means for differentially encoding at least one of the values of the second set related to the at least two subsequent times in the overlap with reference to a value of the first set which is closer in time to the at least one value of the second set than any other value in the second set.

12. A bit-stream representing an encoded signal, the bit-stream comprising:

a first set of encoded values related to subsequent times in a first time interval i,
a second set of encoded values related to subsequent times in a second time interval i+1,
the first time interval having an overlap with the second time interval, the overlap including at least two subsequent times of the second interval,

wherein the second time interval will usually be subsequent in time to the first time interval, but may also be preceding the first time interval,
wherein at least one of the values of the second set related to the at least two subsequent times in the overlap has been differentially encoded with reference to a value of the first set which is closer in time to the at least one value of the second set than any other value in the second set.

13. A storage medium having stored thereon a bit-stream as claimed in claim 12.

14. A method of decoding a bit-stream representing an encoded signal, the decoding comprising:

receiving a first set of encoded values related to subsequent times in a first time interval i,
receiving a second set of encoded value related to subsequent times in a second time interval i+1,
the first time interval having an overlap with the second time interval, the overlap including at least two subsequent times of the second interval,

wherein the second time interval will usually be subsequent in time to the first time interval, but may also be preceding the first time interval,
wherein at least one of the values of the second set related to the at least two subsequent times in the overlap has been differentially encoded with reference to a value of the first set which is closer in time to the at least one value of the second set than any other value in the second set, the decoding further comprising:

decoding the first set of values to obtain a first set of decoded values, and
decoding the second set of values to obtain a second set of decoded values, the at least one of the values of the second set related to the at least two subsequent times in the overlap being decoded with reference to the value of the first set which is closer in time to the at least one value of the second set than any other value in the second set.

15. A decoder for decoding a bit-stream representing an encoded signal, the decoder comprising:

means for receiving a first set of encoded values related to subsequent times in a first time interval i,
means for receiving a second set of encoded values related to subsequent times in a second time interval i+1,
the first time interval having an overlap with the second time interval, the overlap including at least two subsequent times of the second interval,

wherein the second time interval will usually be subsequent in time to the first time interval, but may also be preceding the first time interval,
wherein at least one of the values of the second set related to the at least two subsequent times in the overlap has been differentially encoded with reference to a value of the first set which is closer in time to the at least one value of the second set than any other value in the second set, the decoder further comprising:

means for decoding the first set of values to obtain a first set of decoded values, and
means for decoding the second set of values to obtain a second set of decoded values, the at least one of the values of the second set related to the at least two subsequent times in the overlap being decoded with reference to the value of the first set which is closer in time to the at least one value of the second set than any other value in the second set.

**16.** A transmitter comprising:

an input unit (10) for receiving a signal(s),
an encoder (11) as claimed in claim 11 for encoding the signal (S) to obtain a an encoded signal ([S]), and
an output unit for providing a bit-stream representing the encoded signal ([S]).

**17.** A receiver comprising:

an input unit (30) for receiving a bit-stream representing an encoded signal ([S]),
a decoder (31) as claimed in claim 15 for decoding the encoded signal ([S]) to obtain a decoded signal (S), and
an output unit (32) to provide the decoded signal (S).

**18.** A system comprising a transmitter as claimed in claim 16 and a receiver as claimed in claim 17.

**Patentansprüche**

**1.** Verfahren zur Kodierung eines Signals, wobei das Verfahren enthält:

die Bereitstellung eines ersten Wertesatzes in Bezug auf nachfolgende Zeiten in einem ersten Zeitintervall des Signals,
die Bereitstellung eines zweiten Wertesatzes in Bezug auf nachfolgende Zeiten in einem zweiten Zeitintervall des Signals,

wobei das erste Zeitintervall eine Überlappung mit dem zweiten Zeitintervall hat, die Überlappung mindestens zwei nachfolgende Zeiten des zweiten Intervalls beinhaltet und das zweite Zeitintervall zum ersten Zeitintervall allgemein zeitlich nachfolgend ist, dem ersten Zeitintervall aber auch vorausgehen kann,
und mindestens einer der Werte des zweiten Satzes in Bezug auf mindestens die zwei nachfolgenden Zeiten bei der Überlappung bezüglich eines Werts des ersten Satzes differenziell kodiert wird, welcher zu mindestens dem einen Wert zeitlich näher als jeder andere Wert in dem zweiten Satz ist.

**2.** Verfahren gemäß Anspruch 1, wobei die Überlappung mindestens zwei Zeiten des ersten Zeitintervalls (i) enthält.

**3.** Verfahren gemäß Anspruch 1 oder 2, wobei $g(i,b)$ die Werte in dem ersten Satz (i) und $g(i+1,b)$ die Werte in dem zweiten Satz (i+1) sind, b die Seriennummer eines bestimmten Werts in einem bestimmten Satz bezeichnet und nachfolgende Seriennummern sich auf nachfolgende Zeiten beziehen,
die Überlappung k Zeiten des zweiten Zeitintervalls beinhaltet,
die Werte $g(i,b)$ des ersten Satzes (i) und die Werte $g(i+1,b)$ des zweiten Satzes (i+1) in folgender Sequenz kodiert werden:
$g(i,n-k)$ $g(i,n-k+1)$ $g(i+1,1)$ $g(i,n-k+2)$ $g(i+1,2)$... $g(i,n)$ $g(i+1,k)$ $g(i+1,k+1)$ $g(i+1,k+2)$ ..., und n die höchste Seriennummer im ersten Satz (i) ist.

**4.** Verfahren gemäß Anspruch 1 oder 2, wobei $g(i,b)$ die Werte in dem ersten Satz (i) und $g(i+1,b)$ die Werte in dem zweiten Satz (i+1) sind, b die Seriennummer eines bestimmten Werts in einem bestimmten Satz bezeichnet und nachfolgende Seriennummern sich auf nachfolgende Zeiten beziehen,
die Überlappung k Zeiten des zweiten Zeitintervalls beinhaltet,
die Kodierung umfasst:

Kodierung der Sequenz ... $g(i,n-k)$ $g(i, n-k+1)$ $g(i,n-k+2)$ ... $g(i,n)$,
Kodierung der Sequenz von Zwischenrahmendifferenzen $g(i+1,1)-g(i,n-k+1)$, $g(i+1,2)-g(i,n-k+2)$ ...$g(i+1,k)-g(i, n)$, und n die höchste Seriennummer im ersten Satz ist.

**5.** Verfahren gemäß Anspruch 4, wobei ein Durchschnitt $(m(i+1))$ der Zwischenrahmendifferenzen bestimmt wird und die respektiven Zwischenrahmendifferenzen als Differenzen des besagtes Durchschnitts kodiert werden.

**6.** Verfahren gemäß einem beliebigen der vorhergehenden Ansprüche, wobei eine Anzahl von Zeiten im ersten Zeitintervall (i) bei der Überlappung gleich einer Anzahl von Zeiten im zweiten Zeitintervall (i+1) bei der Überlappung ist.

**7.** Verfahren gemäß einem beliebigen der vorhergehenden Ansprüche, wobei die Werte Werte eines selben Parametertyps sind.

**8.** Verfahren gemäß einem beliebigen der vorhergehenden Ansprüche, wobei die Werte in respektiven Rahmen oder Unterrahmen enthalten sind.

**9.** Verfahren gemäß einem beliebigen der vorhergehenden Ansprüche, wobei das Signal ein Audiosignal ist.

**10.** Verfahren gemäß Anspruch 9, wobei die Werte Verstärkungswerte einer Rauschkomponente im Audiosignal sind.

**11.** Kodierer für die Kodierung eines Signals, wobei der Kodierer enthält:

Mittel für die Bereitstellung eines ersten Wertesatzes in Bezug auf nachfolgende Zeiten in einem ersten Zeitintervall des Signals,
Mittel für die Bereitstellung eines zweiten Wertesatzes in Bezug auf nachfolgende Zeiten in einem zweiten Zeitintervall des Signals,

wobei das erste Zeitintervall eine Überlappung mit dem zweiten Zeitintervall hat, die Überlappung mindestens zwei nachfolgende Zeiten des zweiten Intervalls beinhaltet, das zweite Zeitintervall zum ersten Zeitintervall allgemein zeitlich nachfolgend ist, dem ersten Zeitintervall aber auch vorausgehen kann, und
der Kodierer weiterhin Mittel zur differenziellen Kodierung mindestens einer der Werte des zweiten Satzes in Bezug auf mindestens die zwei nachfolgenden Zeiten bei der Überlappung bezüglich eines Werts des ersten Satzes enthält, welcher zeitlich näher zu mindestens dem einen Wert als jeder andere Wert in dem zweiten Satz ist.

**12.** Bitstrom, der ein kodiertes Signal darstellt, wobei der Bitstrom enthält:

einen ersten Satz kodierter Werte in Bezug auf nachfolgende Zeiten in einem ersten Zeitintervall,
einen zweiten Satze kodierter Werte in Bezug auf nachfolgende Zeiten in einem zweiten Zeitintervall,

wobei das erste Zeitintervall eine Überlappung mit dem zweiten Zeitintervall hat, die Überlappung mindestens zwei nachfolgende Zeiten des zweiten Intervalls beinhaltet und das zweite Zeitintervall zum ersten Zeitintervall allgemein zeitlich nachfolgend ist, dem ersten Zeitintervall aber auch vorausgehen kann, und
mindestens einer der Werte des zweiten Satzes in Bezug auf mindestens die zwei nachfolgenden Zeiten bei der Überlappung bezüglich eines Werts des ersten Satzes differenziell kodiert wurde, welcher zu mindestens dem einen Wert zeitlich näher als jeder andere Wert in dem zweiten Satz ist.

**13.** Speichermittel mit einem darin gespeicherten Bitstrom gemäß Anspruch 12.

**14.** Verfahren zur Dekodierung eines Bitstroms, der ein kodiertes Signal darstellt, wobei die Dekodierung enthält:

den Empfang eines ersten Satzes kodierter Werte, in Bezug auf nachfolgende Zeiten in einem ersten Zeitintervall,
den Empfang eines zweiten Satzes kodierter Werte, in Bezug auf nachfolgende Zeiten in einem zweiten Zeitintervall,

wobei das erste Zeitintervall eine Überlappung mit dem zweiten Zeitintervall hat, die Überlappung mindestens zwei nachfolgende Zeiten des zweiten Intervalls beinhaltet und das zweite Zeitintervall zum ersten Zeitintervall allgemein zeitlich nachfolgend ist, dem ersten Zeitintervall aber auch vorausgehen kann,
mindestens einer der Werte des zweiten Satzes in Bezug auf mindestens die zwei nachfolgenden Zeiten bei der Überlappung bezüglich eines Werts des ersten Satzes differenziell kodiert wurde, welcher zu mindestens dem einen Wert zeitlich näher als jeder andere Wert in dem zweiten Satz ist, die Dekodierung weiterhin enthält:

die Dekodierung des ersten Wertesatzes für den Erhalt eines ersten Satzes dekodierter Werte, und
die Kodierung des zweiten Wertesatzes für den Erhalt eines zweiten Satzes dekodierter Werte, wobei mindestens einer der Werte des zweiten Satzes in Bezug auf mindestens die zwei nachfolgenden Zeiten bei der Überlappung in Bezug auf den Wert des ersten Satzes dekodiert werden, welcher zeitlich näher zu mindestens dem einen Wert als jeder andere Wert in dem zweiten Satz ist.

**15.** Dekodierer zur Dekodierung eines Bitstroms, der ein kodiertes Signal darstellt, wobei der Dekodierer enthält:

Mittel für den Empfang eines ersten Satzes kodierter Werte in Bezug auf nachfolgende Zeiten in einem ersten Zeitintervall,
Mittel für den Empfang eines zweiten Satzes kodierter Werte in Bezug auf nachfolgende Zeiten in einem zweiten Zeitintervall,
das erste Zeitintervall eine Überlappung mit dem zweiten Zeitintervall hat, die Überlappung mindestens zwei nachfolgende Zeiten des zweiten Intervalls beinhaltet und das zweite Zeitintervall zum ersten Zeitintervall allgemein zeitlich nachfolgend ist, dem ersten Zeitintervall aber auch vorausgehen kann,

wobei mindestens einer der Werte des zweiten Satzes in Bezug auf mindestens die zwei nachfolgenden Zeiten bei der Überlappung bezüglich eines Werts des ersten Satzes differenziell kodiert wurden, welcher zeitlich näher zu mindestens dem einen Wert als jeder andere Wert in dem zweiten Satz ist, und der Dekodierer weiterhin enthält:

Mittel zur Dekodierung des ersten Wertesatzes für den Erhalt eines ersten Satzes dekodierter Werte, und
Mittel zur Dekodierung des zweiten Wertesatzes für den Erhalt eines zweiten Satzes dekodierter Werte, wobei mindestens einer der Werte des zweiten Satzes in Bezug auf die mindestens zwei nachfolgenden Zeiten bei der Überlappung in Bezug auf den Wert des ersten Satzes dekodiert wird, welcher zeitlich näher zu mindestens dem einen Wert als jeder andere Wert in dem zweiten Satz ist.

**16.** Sender, der enthält:

eine Eingangseinheit (10) für den Empfang eines Signals (S),
einen Kodierer (11) gemäß Anspruch 11 zur Kodierung des Signals (S) für den Erhalt eines kodierten Signals ([S]), und
eine Ausgangseinheit für die Bereitstellung eines Bitstroms, der das kodierte Signal ([S]) darstellt.

**17.** Empfänger, der enthält:

eine Eingangseinheit (30) für den Empfang eines Bitstroms, der ein kodiertes Signal ([S]) darstellt,
einen Dekodierer (31) gemäß Anspruch 15 zur Dekodierung des kodierten Signals ([S]) für den Erhalt eines dekodierten Signals (S), und
eine Ausgangseinheit (32), um das dekodierte Signal (S) zu erhalten.

**18.** System, das einen Sender gemäß Anspruch 16 und einen Empfänger gemäß Anspruch 17 enthält.


**Revendications**

**1.** Procédé de codage d'un signal, le procédé comprenant :

la fourniture d'une première série de valeurs liées à des moments successifs dans un premier intervalle temporel du signal,
la fourniture d'une deuxième série de valeurs liées à des moments successifs dans un deuxième intervalle temporel du signal,
le premier intervalle temporel possédant un chevauchement avec le deuxième intervalle temporel, le chevauchement comprenant au moins deux moments successifs du deuxième intervalle temporel,

dans lequel le deuxième intervalle temporel sera généralement consécutif dans le temps au premier intervalle temporel mais peut également précéder le premier intervalle temporel,
dans lequel au moins une des valeurs de la deuxième série liée à au moins deux moments successifs dans le chevauchement est codée de manière différentielle par référence à une valeur de la première série qui est plus proche dans le temps d'au moins une valeur de la deuxième série que toute autre valeur dans la deuxième série.

**2.** Procédé selon la revendication 1, dans lequel le chevauchement comprend au moins deux moments du premier intervalle temporel (i).

**3.** Procédé selon l'une des revendications 1 ou 2, dans lequel g(i,b) sont les valeurs dans la première série (i) et g(i+1,b), les valeurs dans la deuxième série (i+1), dans laquelle b désigne le numéro de série d'une valeur donnée dans une série donnée, des numéros de série successifs étant liés à des moments successifs,

le chevauchement comprenant k fois le deuxième intervalle temporel,

dans lequel les valeurs g(i,b) de la première série (i) et les valeurs g(i+1,b) de la deuxième série (i+1) sont codées dans la séquence :

g(i,n-k) g(i,n-k+1) g(i+1,1) g(i,n-k+2) g(i+1,2) ... g(i,n) g(i+1,k) g(i+1,k+1) g(i+1,k+2) ..., dans laquelle n est le nombre de série le plus élevé dans la première série (i).

4. Procédé selon l'une des revendications 1 ou 2, dans lequel g(i,b) sont les valeurs dans la première série (i) et g(i+1,b) les valeurs dans la deuxième série (i+1), dans laquelle b désigne le numéro de série d'une valeur donnée dans une série donnée, les numéros de série successifs étant liés à des moments successifs,

le chevauchement comprenant k fois le deuxième intervalle temporel ;

dans lequel le codage comprend :

le codage de la séquence... g(i,n-k) g(i,n-k+1) g(i,n-k+2) ... g(i,n),

le codage de la séquence des différences inter-trames g(i+1,1)-g(i,n-k+1), g(i+1,2)-g(i,n-k+2) ... g(i+1,k)-g(i,n) dans laquelle n est le numéro de série le plus élevé dans la première série.

5. Procédé selon la revendication 4, dans lequel une moyenne (m(i+1)) des différences inter-trames est déterminée et dans lequel les différences inter-trames respectives sont codées comme des différences par rapport à ladite moyenne.

6. Procédé selon l'une des revendications précédentes, dans lequel un nombre de temps dans le premier intervalle temporel (i) dans le chevauchement est égal à un nombre de temps dans le deuxième intervalle temporel (i+1) dans le chevauchement.

7. Procédé selon l'une des revendications précédentes dans lequel les valeurs sont les valeurs d'un même type de paramètre.

8. Procédé selon l'une des revendications précédentes dans lequel les valeurs sont incluses dans des trames ou sous-trames respectives.

9. Procédé selon l'une des revendications précédentes dans lequel le signal est un signal audio.

10. Procédé selon la revendication 9, dans lequel les valeurs sont des valeurs de gain d'un élément de bruit dans le signal audio.

11. Codeur pour coder un signal, le codeur comprenant :

des moyens pour la fourniture d'une première série de valeurs liées à des moments successifs dans un premier intervalle temporel du signal,

des moyens pour la fourniture d'une deuxième série de valeurs liées à des moments successifs dans un deuxième intervalle temporel du signal,

le premier intervalle temporel possédant un chevauchement avec le deuxième intervalle temporel, le chevauchement comprenant au moins deux moments successifs du deuxième intervalle temporel,

dans lequel le deuxième intervalle temporel sera généralement consécutif dans le temps au premier intervalle temporel mais peut également précéder le premier intervalle temporel,

le codeur comprenant par ailleurs des moyens pour le codage différentiel d'au moins une des valeurs de la deuxième série liée à au moins deux moments successifs dans le chevauchement par référence à une valeur de la première série qui est plus proche dans le temps d'au moins une valeur de la deuxième série que toute autre valeur dans la deuxième série.

12. Train de bits représentant un signal codé, le train de bits comprenant :

une première série de valeurs codées liées à des moments successifs dans un premier intervalle temporel,

une deuxième série de valeurs codées liées à des moments successifs dans un deuxième intervalle temporel,

le premier intervalle temporel possédant un chevauchement avec le deuxième intervalle temporel, le chevauchement comprenant au moins deux moments successifs du deuxième intervalle temporel,

dans lequel le deuxième intervalle temporel sera généralement consécutif dans le temps au premier intervalle temporel mais peut également précéder le premier intervalle temporel,
dans lequel au moins une des valeurs de la deuxième série liée à au moins deux moments successifs dans le chevauchement est codée de manière différentielle par référence à une valeur de la première série qui est plus proche dans le temps d'au moins une valeur de la deuxième série que toute autre valeur dans la deuxième série.

**13.** Support d'enregistrement sur lequel est enregistré un train de bits selon la revendication 12.

**14.** Procédé de décodage d'un train de bits représentant un signal codé, le décodage comprenant :

la réception d'une première série de valeurs codées liées à des moments successifs dans un premier intervalle temporel,
la réception d'une deuxième série de valeurs liées à des moments successifs dans un deuxième intervalle temporel,
le premier intervalle temporel possédant un chevauchement avec le deuxième intervalle temporel, le chevauchement comprenant au moins deux moments successifs du deuxième intervalle temporel,

dans lequel le deuxième intervalle temporel sera généralement consécutif dans le temps au premier intervalle temporel mais peut également précéder le premier intervalle temporel,
dans lequel au moins une des valeurs de la deuxième série liée à au moins deux moments successifs dans le chevauchement a été codée de manière différentielle par référence à une valeur de la première série qui est plus proche dans le temps d'au moins une valeur de la deuxième série que toute autre valeur dans la deuxième série,
le décodage comprenant par ailleurs :

le décodage de la première série de valeurs pour obtenir une première série de valeurs décodées et
le décodage de la deuxième série de valeurs pour obtenir une deuxième série de valeurs décodées, au moins l'une des valeurs de la deuxième série liée à au moins deux moments successifs dans le chevauchement étant décodée par référence à la valeur de la première série qui est plus proche dans le temps d'au moins une valeur de la deuxième série que tout autre valeur dans la deuxième série.

**15.** Décodeur pour décoder un train de bits représentant un signal codé, le décodeur comprenant :

des moyens pour recevoir une première série de valeurs codées liées à des moments successifs dans un premier intervalle temporel,
des moyens pour recevoir une deuxième série de valeurs codées liées à des moments successifs dans un deuxième intervalle temporel,
le premier intervalle temporel possédant un chevauchement avec le deuxième intervalle temporel, le chevauchement comprenant au moins deux moments successifs du deuxième intervalle temporel,

dans lequel le deuxième intervalle temporel sera généralement consécutif dans le temps au premier intervalle temporel mais peut également précéder le premier intervalle temporel,
dans lequel au moins une des valeurs de la deuxième série liée à au moins deux moments successifs dans le chevauchement a été codée de manière différentielle par référence à une valeur de la première série qui est plus proche dans le temps d'au moins une valeur de la deuxième série que toute autre valeur dans la deuxième série,
le décodeur comprenant par ailleurs :

des moyens de décodage de la première série de valeurs pour obtenir une première série de valeurs décodées, et
des moyens de décodage de la deuxième série de valeurs pour obtenir une deuxième série de valeurs décodées, au moins l'une des valeurs de la deuxième série liée à au moins deux moments successifs dans le chevauchement étant décodée par référence à la valeur de la première série qui est plus proche dans le temps d'au moins une valeur de la deuxième série que tout autre valeur dans la deuxième série.

**16.** Émetteur comprenant :

une unité d'entrée (10) pour recevoir un signal (S)

un codeur (11) selon la revendication 11 pour coder le signal (S) afin d'obtenir un signal codé ([S]) et une unité de sortie pour fournir un train de bits représentant le signal codé ([S]).

**17.** Récepteur comprenant :

une unité d'entrée (30) pour recevoir un train de bits représentant un signal codé ([S]), un décodeur (31) selon la revendication 15 pour décoder le signal codé ([S]) afin d'obtenir un signal décodé (S) et une unité de sortie (32) pour fournir le signal décodé (S).

**18.** Un système comprenant un émetteur selon la revendication 16 et un récepteur selon la revendication 17.

FIG. 1

FIG. 2

FIG. 3

FIG. 4